# EUROPÄISCHE PATENTSCHRIFT

(11) **EP 1 618 570 B1**
(45) Veröffentlichungstag und Bekanntmachung des Hinweises auf die Patenterteilung: **22.10.2008**
(21) Anmeldenummer: 04721201.4
(22) Anmeldetag: 17.03.2004
(51) Int. Cl.: G11C 5/02, H01L 23/538

(54) **SPEICHER-SCHALTUNGSANORDNUNG UND VERFAHREN ZUR HERSTELLUNG**
MEMORY-CIRCUIT ARRANGEMENT AND METHOD FOR THE PRODUCTION THEREOF
SYSTEME DE CIRCUIT-MEMOIRE ET PROCEDE DE PRODUCTION CORRESPONDANT

(30) Priorität: 29.04.2003 DE 10319271
(43) Veröffentlichungstag der Anmeldung: 25.01.2006
(73) Patentinhaber: Infineon Technologies AG, 81669 München (DE)
(72) Erfinder: GRUBER, Wolfgang, 82140 Neu-Esting (DE); KAKOSCHKE, Ronald, 81475 München (DE); SCHWEIZER, Thomas, 85560 Ebersberg (DE); WEGERTSEDER, Dominik, 85540 Haar (DE)
(74) Vertreter: Karl, Frank
(86) Internationale Anmeldenummer: PCT/EP2004/050322
(87) Internationale Veröffentlichungsnummer: WO 2004/097838

(56) Entgegenhaltungen:
- US-A- 5 386 623
- WANG M ET AL: "Configurable area-IO memory for system-in-a-package (SiP)" ESSCIRC 2001. PROCEEDINGS OF THE 27TH EUROPEAN SOLID-STATE CIRCUITS CONFERENCE FRONTIER GROUP PARIS, FRANCE, [Online] Seiten 400-403, XP002298626 2001-09-20 ISBN: 2-914601-00-X Gefunden im Internet: URL:http://www.imec.be/esscirc/esscirc2001 /Proceedings/data/69.pdf>
- GOETZ M: "System on chip design methodology applied to system in package architecture" 52ND ELECTRONIC COMPONENTS AND TECHNOLOGY CONFERENCE 2002. (CAT. NO.02CH37345) IEEE PISCATAWAY, NJ, USA, [Online] Seiten 254-258, XP002298625 2002-05-31 ISBN: 0-7803-7430-4 Gefunden im Internet: URL:http://ieeexplore.ieee.org/xpl/abs_fre e.jsp?arNumber=1008103>

## Beschreibung

Die Erfindung betrifft eine Speicher-Schaltungsanordnung mit einem Substrat für ein Speicherzellenfeld und mit einem Substrat für eine Logikschaltung zur Ansteuerung des Speicherzellenfeldes.

Bei den Speicher-Schaltungsanordnungen werden unterschieden:
- nicht-flüchtige Speicherschaltungen, die ihren Speicherinhalt auch nach dem Ausschalten einer Versorgungsspannung des Speicherschaltkreises behalten, z.B. ROM-Schaltkreise (Read Only Memory) bzw. EEPROM-Schaltkreise (Electrical Eraseable Programmable Read Only Memory),
- flüchtige Speicherschaltkreise, die ihren Speicherinhalt nach dem Ausschalten einer Versorgungsspannung für den Speicherschaltkreis verlieren, z.B. DRAM-Schaltkreise (Dynamic Random Access Memory) oder SRAM-Schaltkreise (Static Random Access Memory).

Diesen Speicherschaltkreisen ist gemeinsam, dass sich auf einem Substrat, z.B. auf einem Halbleitersubstrat, insbesondere auf einem Siliziumsubstrat, sowohl das Speicherzellenfeld als auch die Logikschaltung befinden, siehe beispielsweise DE 198 19 542. Die Speicher-Schaltungsanordnungen werden bei sogenannten eingebetteten Systemen gemeinsam mit einem Prozessor auf einem Substrat gefertigt. Andererseits gibt es auch sogenannte System-In-Package-Schaltkreise, bei denen ein Speicherchip und ein Prozessor-Chip in einem Schaltkreisgehäuse angeordnet werden. Auch bei sogenannten Multi-Chip-Modulen sind in einem Schaltkreis mehrere "Standard"-Schaltkreise enthalten, z.B. ein Speicherschaltkreis und ein Prozessorschaltkreis.

Die US 5,386,623 betrifft einen Mikrocontroller, der als eine MCM (Multi-Chip-Module) aufgebaut ist. Der Mikrocontroller ist nach funktionalen Betrachtungen auf verschiedene Chips aufgeteilt, nämlich u.a. auf einen Prozessor bzw. Mikrocomputerchip und auf Speicherchips (RAM, ROM), die jeweils eine Speicherschaltung enthalten.

Aus dem Artikel von M. Wang u. a., "Configurable area-IO memory for system-in-a-package (SiP)", ESSCIR 2001, Seiten 400 bis 4033, ist ein SiP (System-in-a-Package) bekannt, das eine konfigurierbare Speicherarchitektur enthält. Einzelne Speicherblöcke enthalten vollständige Datenanschlüsse, Adressdatenanschlüsse und die Zugriffssteuerlogik. Eine separate Konfigurationssteuerung (Configuration Control Logic) konfiguriert den Speicherbaustein und hat u. a. zentrale Datenanschlüsse, Adressdatenanschlüsse. Die Speicherblöcke und die Konfigurationssteuerung sind auf voneinander verschiedenen Substraten angeordnet.

Die US 20020114178 betrifft eine Speicher-Schaltungsanordnung, die als eine MCM aufgebaut ist. Eines der Substrate enthält einen nicht flüchtigen Speicher, dessen Steuerschaltung auf einem separaten Substrat enthalten ist.

Es ist Aufgabe der Erfindung, eine einfach und kostengünstig herzustellende Speicher-Schaltungsanordnung sowie ein einfaches Verfahren zur Herstellung einer Speicher-Schaltungsanordnung anzugeben.

Die auf die Schaltungsanordnung bezogene Aufgabe wird durch eine Schaltungsanordnung mit den im Patentanspruch 1 angegebenen Merkmalen gelöst. Weiterbildungen sind in den Unteransprüchen angegeben.

Die Erfindung geht von der Überlegung aus, dass der Gesamtherstellungsaufwand maßgeblich vom Aufwand für die Herstellung einer bestimmten Chipfläche abhängt. Durch eine geschickte Aufteilung der Einheiten einer Speicher-Schaltungsanordnung, insbesondere auf Grund von Technologiebetrachtungen, lässt sich auf einfache Art erreichen, dass die Herstellungskosten je Chipfläche erheblich sinken, auch wenn ein zusätzlicher Montageaufwand berücksichtigt wird, mit dem die getrennt gefertigten Bestandteile miteinander verbunden werden. Sinkt beispielsweise die Anzahl der Verfahrensschritte zur Herstellung einer Teilschaltung um ein Drittel im Vergleich zur Herstellung der Speicher-Schaltungsanordnung auf nur einem einzigen Substrat, so wird die Verfahrensführung erheblich einfacher. Der Herstellungsaufwand bezogen auf eine Chipfläche verringert sich dann für jede Teilschaltung beispielsweise um mehr als die Hälfte im Vergleich zum Herstellungsaufwand je Chipfläche bei einer Herstellung der Speicher-Schaltungsanordnung auf einem einzigen Substrat. Bei einer Addition des Herstellungsaufwandes für die beiden Teilchipflächen ergibt sich ein Herstellungsaufwand, der erheblich unter dem Herstellungsaufwand liegt, der sich ergibt, wenn die integrierte Schaltungsanordnung auf nur einem Substrat hergestellt wird.
Deshalb enthält die erfindungsgemäße Speicher-Schaltungsanordnung ein Zellenfeldsubstrat, das ein integriertes Speicherzellenfeld aus einer Vielzahl von Speicherzellen trägt. Jede Speicherzelle enthält mindestens einen Transistor, z.B. einen Transistor mit Floating-Gate oder alternativ einen Transistor und einen Speicherkondensator. Außerdem enthält die erfindungsgemäße Speicher-Schaltungsanordnung ein Logikschaltungssubstrat, das mindestens eine integrierte Logikschaltung zum Steuern des Zugriffs auf die Speicherzellen im Rahmen der Grundfunktionen der Speicher-Schaltungsanordnung trägt. Die Grundfunktionen sind das Lesen, das Schreiben bzw. das Löschen des Inhaltes einer oder mehrerer Speicherzellen des Speicherzellenfeldes. Auch eine Auswahl bestimmter Speicherzellen des Speicherzellenfeldes abhängig von einem an der Speicherschaltung anliegenden Adressdatums betrifft bei einer Ausgestaltung die Grundfunktion der Speicher-Schaltungsanordnung.

Bei der erfindungsgemäßen Speicher-Schaltungsanordnung ist das Logikschaltungssubstrat ein anderes Substrat als das Zellenfeldsubstrat. Insbesondere wurden die auf beiden Substraten angeordneten integrierten Schaltungsanordnungen in voneinander getrennten Herstellungsverfahren gefertigt.

Bei einer Weiterbildung der erfindungsgemäßen Schaltungsanordnung hat das Zellenfeldsubstrat Substratoberflächen, die nur das Zellenfeldsubstrat und nicht das Logikschaltungssubstrat allseitig umgeben. Umgekehrt hat das Logikschaltungssubstrat Substratoberflächen, die nur das Logikschaltungssubstrat und nicht das Zellenfeldsubstrat allseitig umgeben. Die Substratoberflächen sind insbesondere Trennflächen oder polierte Trennflächen.

Bei einer anderen Weiterbildung sind die Speicherzellen des Speicherzellenfeldes flüchtige Speicherzellen. Bei einer alternativen Weiterbildung sind die Speicherzellen des Speicherzellenfeldes nicht-flüchtige Speicherzellen, insbesondere sogenannte Flash-Speicherzellen, bei denen bei jedem Löschvorgang eine Vielzahl von Speicherzellen gelöscht werden. Besonders bei nicht-flüchtigen Speicherzellen sind die Technologieunterschiede bei der Herstellung des Zellenfeldes und bei der Herstellung Peripherieschaltungen erheblich. Die Unterschiede werden bei kleineren minimalen Strukturbreiten und mit der Nutzung neuer Speicherprinzipien größer, beispielsweise bei ferroelektrischen oder magnetoresistiven Speicherzellen bzw. bei Speicherzellen, bei denen ein Wechsel zwischen einer amorphen und einer kristallinen Phase zum Speichern genutzt wird.

Bei einer nächsten Weiterbildung trägt das Logikschaltungssubstrat eine Steuerschaltung, die Abläufe beim Lesen, Abläufe beim Schreiben und Abläufe beim Löschen einer Speicherzelle des Speicherzellenfeldes steuert. Insbesondere muss die Abfolge von Steuersignalen durch die Steuerschaltung gewährleistet werden. Bspw. wird bei nicht-flüchtigen Speicherschaltkreisen vom NOR-Typ die Steuerschaltung als FACE (Flash Algorithmic Control Engine) bezeichnet. Bei integrierten Schaltungen vom NAND-Typ und anderen Typen gibt es ähnliche zentrale Steuerschaltungen zum Steuern der Funktion des Speicherschaltkreises.

Alternativ oder kumulativ enthält das Logikschaltungssubstrat bei einer nächsten Weiterbildung eine Leseverstärkerschaltung, mit deren Hilfe sich der Speicherzustand einer Speicherzelle ermitteln lässt. Die Leseschaltung wird auch als Sense Amplifier bezeichnet.

Bei einer anderen Weiterbildung enthält das Logikschaltungssubstrat mindestens eine Dekodierschaltung, die aus einem Adressdatum eine Sammelleitung auswählt, die an mehrere Speicherzellen des Speicherzellenfeldes angeschlossen ist, jedoch nicht an alle Speicherzellen des Speicherzellenfeldes. Eine Sammelleitung, die an Speicherzellen einer Zeile aus Speicherzellen des Speicherzellenfeldes angeschlossen ist, wird auch als Wortleitung bezeichnet. Die Wortleitungen sind bspw. mit den Gateelektroden von Transistoren der Speicherzellen verbunden. Eine Sammelleitung, die an Speicherzellen einer Spalte aus Speicherzellen des Speicherzellenfeldes angeschlossen ist, wird auch als Bitleitung bezeichnet. Die Bitleitungen sind bspw. mit Source-/Drain-Gebieten von Feldeffekt-Transistoren der Speicherzellen verbunden. Außerdem gibt es bei der Weiterbildung elektrisch leitfähige Verbindungen zwischen dem Zellenfeldsubstrat und dem Logikschaltungssubstrat für jede Sammelleitung, insbesondere Verbindungen einer der folgenden Verbindungsarten:
- elektrisch leitfähige Lötverbindung,
- elektrisch leitfähige Klebeverbindung,
- elektrisch leitfähige Schweißverbindung,
- elektrisch leitfähige Bondverbindung,
- durch Aushärten eines ein Lösungsmittel enthaltenden Gemisches entstehende Verbindung, beispielsweise gemäß EP 0 610 709 A1, oder
- das Speicherzellensubstrat in seiner gesamten Dicke oder das Logikschaltungssubstrat in seiner gesamten Dicke durchdringende Metallisierungsverbindung, siehe DE 199 04 751 C1.

Die Anzahl der Verbindungen zwischen den Substraten hängt bei dieser Weiterbildung von der Anzahl der Wortleitungen und/oder der Anzahl der Bitleitungen ab. So liegt die Anzahl der Verbindungen beispielsweise bei über 1000, bei über 2000 oder bei über 3000 abhängig von der Speicherkapazität des Speicherzellenfeldes.

Bei einer anderen Weiterbildung der erfindungsgemäßen Schaltungsanordnung trägt das Logikschaltungssubstrat eine Schaltungsanordnung mindestens eines Prozessors, der zur Bearbeitung von Programmbefehlen geeignet ist, insbesondere zur Bearbeitung von im Speicherzellenfeld gespeicherten Programmbefehlen. Der Prozessor enthält unter anderem ein Rechenwerk und ein Steuerwerk, in dem bspw. ein Mikroprogramm ausgeführt wird. Bei einer Weiterbildung enthält das Logikschaltungssubstrat eine Schaltungsanordnung für zwei Prozessoren, nämlich für einen Hauptprozessor und einen Co-Prozessor. Der Co-Prozessor ist beispielsweise ein Prozessor, der einen Verschlüsselungsalgorithmus zum Verschlüsseln von Daten ausführt. Eine Schaltungsanordnung mit Speicher-Schaltungsanordnung, Prozessor und Co-Prozessor wird bei einer Ausgestaltung in eine sogenannte Chipkarte mit einer Dicke kleiner als 2 mm eingebaut.

Bei einer anderen Weiterbildung trägt das Zellenfeldsubstrat mindestens einen Sensor, beispielsweise einen Spannungssensor oder einen Stromsensor. Zusätzlich oder alternativ enthält das Zellenfeldsubstrat bei der Weiterbildung einen Analog-Digital-Wandler, beispielsweise zum Umwandeln der von einem Sensor erzeugten analogen Ausgangssignale in ein digitales Datum.

Bei einer nächsten Weiterbildung liegen eine Hauptfläche des Zellenfeldsubstrats und eine Hauptfläche des Logikschaltungssubstrats in zwei zueinander parallelen Ebenen, vorzugsweise mit Überlappung in Normalenrichtung der einen Hauptfläche. Eine Hauptfläche ist dabei im Gegensatz zu einer Randfläche eine Fläche mit einem erheblich größeren Flächeninhalt als die Randfläche. Bei dieser Weiterbildung werden die beiden Substrate und gegebenenfalls auch weitere Substrate der Schaltungsanordnung übereinander gestapelt. Im Gegensatz zu bisherigen Stapeln aus Substraten liegen bei der Weiterbildung jedoch Baugruppen einer Speicherschaltungsanordnung auf verschiedenen Substraten des Substratstapels.

Alternativ lässt sich auch ein Trägersubstrat verwenden, auf dem bspw. mehrere quer zum Trägersubstrat liegende Substrate aufgereiht sind. In diesem Fall liegt eine Hauptfläche des Zellenfeldsubstrats quer zu einer Hauptfläche des Logikschaltungssubstrats.

Die Erfindung betrifft außerdem ein Verfahren zum Herstellen einer Speicher-Schaltungsanordnung mit den folgenden Schritten:
- Fertigen eines integrierten Speicherzellenfeldes auf einem Speicherzellensubstrat mit einer ersten Folge von Verfahrensschritten,
- Fertigen einer integrierten Logikschaltung zum Erbringen von Grundfunktionen des Speicherzellenfeldes auf einem vom Speicherzellensubstrat getrennten Logikschaltungssubstrat mit einer von der ersten Folge abweichenden zweiten Folge von Verfahrensschritten, und
- Anordnen des integrierten Speicherzellenfeldes und der integrierten Schaltungsanordnung zu einer Speicher-Schaltungsanordnung.

Insbesondere betreffen die beiden Folgen von Verfahrensschritten verschiedene Herstellungstechnologien, beispielsweise Herstellungstechnologien mit voneinander unterschiedlichen minimalen Strukturbreiten. Die erste Folge von Verfahrensschritten lässt sich vor der Durchführung der zweiten Folge von Verfahrensschritten ausführen. Umgekehrt kann jedoch auch die zweite Folge von Verfahrensschritten vor der ersten Folge von Verfahrensschritten durchgeführt werden. Auch eine gleichzeitige Durchführung der beiden Folgen von Verfahrensschritten am gleichen Produktionsstandort oder an verschiedenen Produktionsstandorten ist möglich. Bei einer Durchführung am gleichen Produktionsstandort werden bspw. verschiedene Maschinen für Verfahrensschritte beider Verfahren eingesetzt. Bei der Nutzung der gleichen Maschinen werden die Verfahrensschritte verschiedener Folgen hintereinander ausgeführt.

Für das erfindungsgemäße Verfahren gelten die oben im Zusammenhang mit der erfindungsgemäßen Speicher-Schaltungsanordnung genannten technischen Wirkungen ebenfalls.

Bei einer Weiterbildung enthält die erste Folge Verfahrensschritte, die für die Herstellung eines Speicherzellenfeldes besonders geeignet sind und die bei der Herstellung der Logikschaltung nicht benötigt werden. Umgekehrt enthält bei einer zusätzlichen oder alternativen Weiterbildung die zweite Folge Verfahrensschritte, die besonders zur Herstellung von Logikschaltungen geeignet sind und die bei der Herstellung eines Speicherzellenfeldes nicht benötigt werden. Durch diese Vorgehensweise entsteht ein aus zwei Teilverfahren bestehendes Verfahren, dessen Herstellungsaufwand in Summe geringer ist als ein Verfahren, bei dem sowohl das Speicherzellenfeld als auch die Logikschaltung mit derselben Technologie hergestellt werden müssen bzw. bei dem mit Hinblick auf die Logikschaltung bzw. auf das Speicherzellenfeld bestimmte Kompromisse beim Herstellen des Speicherzellenfeldes bzw. beim Herstellen der Logikschaltung eingegangen werden müssen.

Die Erfindung ist in den Anspruchen 1 und 7 definiert.

Im Folgenden werden Ausführungsbeispiele der Erfindung an Hand der beiliegenden Zeichnungen erläutert. Darin zeigen:
- Figur 1: die Aufteilung von Schaltungsteilen einer Schaltungsanordnung auf zwei Substrate mit einer kleinen Anzahl von Verbindungsstellen zwischen den Substraten,
- Figur 2: die Aufteilung von Schaltungsteilen einer Schaltungsanordnung auf zwei Substrate mit einer Vielzahl Verbindungsstellen zwischen Wortleitungen und Bitleitungen,
- Figur 3: einen Querschnitt durch einen Substratstapel mit drei Substraten während der Herstellung einer Schaltungsanordnung,
- Figur 4: eine Draufsicht auf einen Substratstapel mit zwei durch eine Plättchen-Schnellmontagetechnik verbundenen Substraten, und
- Figur 5: einen Querschnitt durch den Substratstapel mit zwei Substraten.

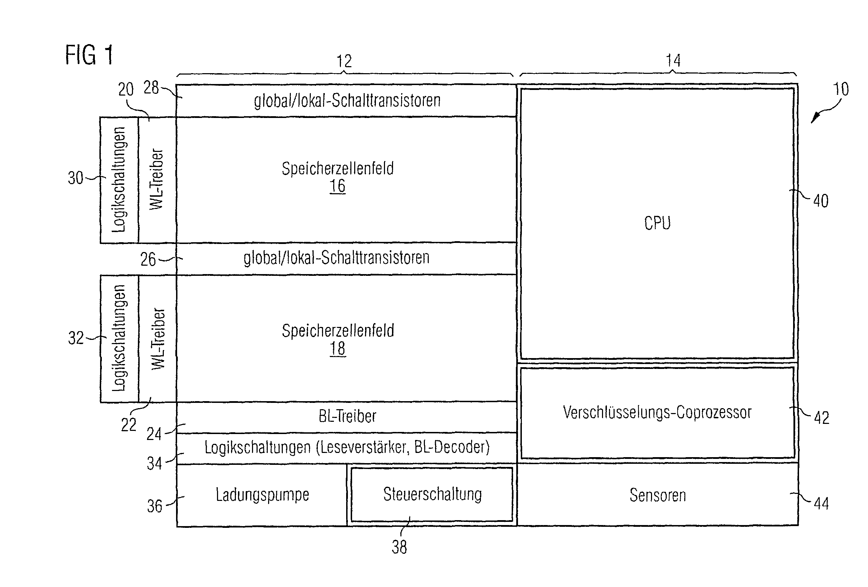

Figur 1 zeigt Schaltungsblöcke einer Schaltungsanordnung 10. In einem linken Teil 12 der Schaltungsanordnung 10 liegen Schaltungsblöcke einer Speicherschaltung. In einem rechten Teil 14 der Schaltungsanordnung 10 liegen Zusatzschaltungen, die zusätzlich zur Speicherschaltung in der Schaltungsanordnung 10 vorgesehen sind. Die Zusatzschaltungen nutzen beim Betrieb der Schaltungsanordnung 10 jedoch die Speicherschaltung.

Die Speicherschaltung ist beispielsweise eine Speicherschaltung mit nicht-flüchtig ladungsspeichernden Speicherzellen oder mit flüchtig ladungsspeichernden Speicherzellen. Im Ausführungsbeispiel enthält die Speicherschaltung zwei oder mehrere Speicherzellenfelder 16, 18, in denen Speicherzellen matrixförmig in Zeilen und Spalten angeordnet sind. Speicherzellen einer Zeile werden durch Wortleitungen verbunden, die zu Wortleitungs-Treibertransistoren 20, 22 am linken Rand des Speicherzellenfeldes 16 bzw. 18 führen. Bitleitungen verbinden dagegen die Speicherzellen einer Spalte eines Speicherzellenfeldes 16 bzw. 18 und führen zu Bitleitungs-Treibertransistoren 24 am unteren Rand des Speicherzellenfeldes 18. Die Treibertransistoren 20 bis 24 dienen zur Pegelumsetzung.

Eine Schalttransistorgruppe 26 ist zwischen den beiden Speicherzellenfeldern 16 und 18 angeordnet. Eine weitere Schalttransistorgruppe 28 befindet sich oberhalb des Speicherzellenfeldes 16. Die Schalttransistoren der Schalttransistorgruppen 26 und 28 dienen zum Anschluss speicherzellenfeldinterner bzw. sogenannter lokaler Bitleitungen an Bitleitungen, die über oder durch mehrere Speicherzellenfelder 16, 18 verlaufen. Die Wortleitungs-Treibertransistoren 20 bzw. die Wortleitungs-Treibertransistoren 22 werden von einer Wortleitungs-Dekodierschaltung 30 bzw. von einer Wortleitungs-Dekodierschaltung 32 angesteuert. Die Dekodierschaltung 30 bzw. 32 wählt abhängig von einem Adressdatum zur Angabe einer Wortleitung eine Wortleitung aus, bspw. durch anlegen einer Spannung nur an die ausgewählte Wortleitung..

Die Bitleitungs-Treibertransistoren 24 werden durch eine Bitleitungs-Dekodierschaltung angesteuert, die abhängig von einem Adressdatum zur Bezeichnung einer Bitleitung eine Bitleitung auswählt. Die Bitleitungs-Dekodierschaltung ist eine von mehreren Logikschaltungen 34 zum Erbringen der Grundfunktionen der Speicherschaltung. Zu den Logikschaltungen 34 gehört beispielsweise auch ein sogenannter Leseverstärker, mit dessen Hilfe sich der Speicherzustand einer Speicherzelle ermitteln lässt.

Zur Speicherschaltung gehört weiterhin eine Ladungspumpe 36, mit deren Hilfe Spannungen erzeugt werden, die notwendig sind, um die Speicherzellen des Speicherzellenfeldes zu löschen oder zu beschreiben. Außerdem enthält die Speicherschaltung zum Erbringen ihrer grundlegenden Funktionen eine Steuerschaltung 38, die übergeordnete Steuerfunktionen in der Speicherschaltung übernimmt, insbesondere:
- die Steuerung des Programmierens, des Lesens und/oder des Löschens, und
- die Steuerung der Dekodierschaltungen 30, 32, der Logikschaltungen 34 und/oder der Ladungspumpe 36.

Der rechte Teil der Schaltungsanordnung 10 enthält im Ausführungsbeispiel:
- einen Prozessor 40, beispielsweise mit einem Aufbau wie ein handelsüblicher Mikroprozessor,
- einen Verschlüsselungs-Co-Prozessor 42, der beispielsweise gemäß RSA-Algorithmus (Revist, Schamir und Adlemann) bzw. gemäß DES-Algorithmus (Data Encryption Standard) arbeitet, und
- ein Sensorenfeld 44 mit mehreren Strom- und Spannungssensoren sowie mit mehreren Analog-Digital-Wandlern zum Umwandeln der analogen Sensorsignale in digitale Daten.

Gemäß einem ersten Ausführungsbeispiel werden die in Figur 1 dargestellten Schaltungsblöcke der Schaltungsanordnung 10 so auf zwei verschiedene Substrate aufgeteilt, dass das eine Substrat das Sensorfeld 44 und alle Teile der Speicherschaltung bis auf die Steuerschaltung 38 trägt, d.h. alle in Figur 1 nur einfach umrandeten Funktionsblöcke, nämlich:
- die Speicherzellenfelder 16, 18,
- die Wortleitungs-Treibertransistoren 20, 22,
- die Bitleitungs-Treibertransistoren 24,
- die Wortleitungs-Dekodierschaltungen 30, 32,
- die Logikschaltungen 34,
- die Ladungspumpe 36, und
- die Sensoren und Wandler des Sensorfeldes 44.

Dagegen trägt beim ersten Ausführungsbeispiel das zweite Substrat die in Figur 1 durch eine doppelte Umrahmung umgebenen Funktionsblöcke, nämlich:
- die Steuerschaltung 38,
- den Prozessor 40, und
- den Verschlüsselungs-Co-Prozessor 42.

Auf dem zweiten Substrat befindet sich damit nur die Steuerschaltung 38 der Speicherschaltung, so dass zwischen den Schaltungen auf beiden Substraten nur eine vergleichbar geringe Anzahl von elektrisch leitfähigen Verbindungen hergestellt werden muss, beispielsweise weniger als 100 Verbindungen, z.B. sogenannte Lötbumps.

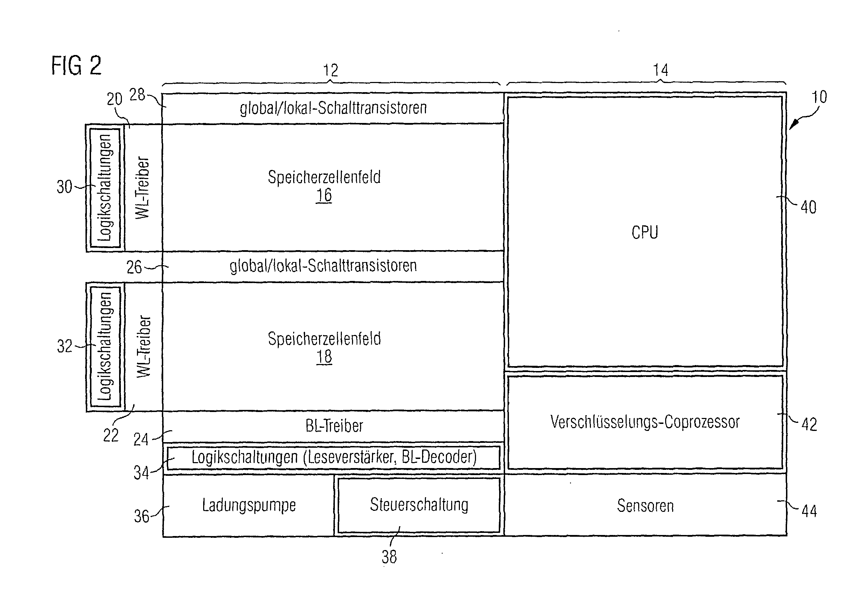

Figur 2 zeigt eine Aufteilung der Funktionsblöcke der Schaltungsanordnung 10 auf zwei Substrate gemäß einem zweiten Ausführungsbeispiel. Beim zweiten Ausführungsbeispiel enthält das eine Substrat die in Figur 2 von einer einfachen Umrahmung umgebenen Funktionsblöcke der Schaltungsanordnung 10, nämlich:
- die Speicherzellenfelder 16, 18,
- die Wortleitungs-Treibertransistoren 20, 22, sowie
- die Bitleitungs-Treibertransistoren 24,
- die Ladungspumpe 36, und
- die Sensoren und Wandler des Sensorfeldes 44.

Das zweite Substrat enthält gemäß dem zweiten Ausführungsbeispiel dagegen die in Figur 2 von einer doppelten Umrahmung umgebenen Funktionsblöcke, nämlich:
- die Wortleitungs-Dekodierschaltungen 30, 32,
- die Logikschaltungen 34,
- die Steuerschaltung 38,
- den Prozessor 40, und
- den Verschlüsselungs-Co-Prozessor 42.

Die Anzahl der Verbindungen zwischen den beiden Substraten ist beim zweiten Ausführungsbeispiel sehr groß, da jeder Wortleitung und jeder Bitleitung der Speicherschaltung eine Verbindung zugeordnet ist. Beispielsweise verbinden mehrere tausend Verbindungen die beiden Substrate.

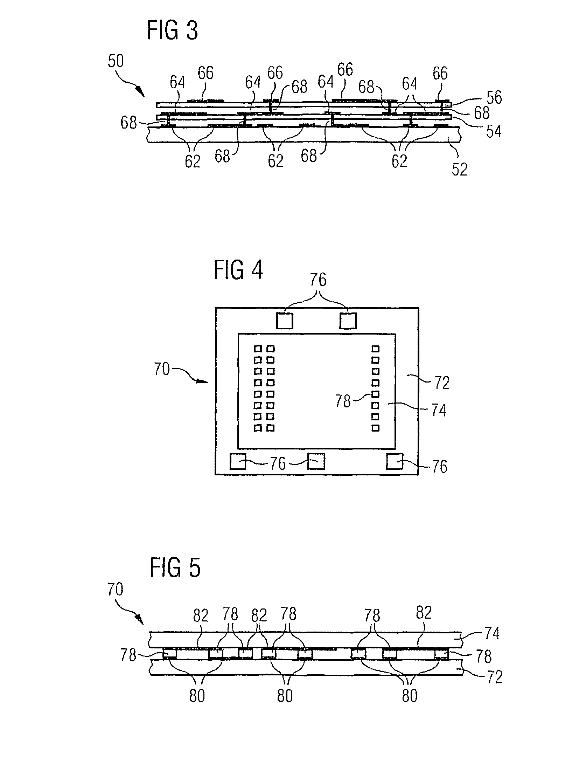

Figur 3 zeigt einen Querschnitt durch einen Substratstapel 50 während der Herstellung einer Schaltungsanordnung, die beispielsweise gleiche oder ähnliche Funktionsblöcke wie die Schaltungsanordnung 10 enthält. Der Substratstapel 50 enthält ein unteres Bodensubstrat 52, ein über dem Bodensubstrat 52 angeordnetes Zwischensubstrat 54 und ein über dem Zwischensubstrat angeordnetes Decksubstrat 56. Bei dem in Figur 3 dargestellten Fertigungszustand ist das Bodensubstrat 52 noch Bestandteil eines Halbleiterwafers, der eine Vielzahl von Bodensubstraten 52 enthält, die am Ende des Fertigungsprozesses voneinander getrennt werden. Das Bodensubstrat 52 ist beispielsweise mindestens doppelt so dick wie das Zwischensubstrat 54 oder das Decksubstrat 56.

Das Zwischensubstrat 54 und das Decksubstrat 56 sind bei einem ersten Ausführungsbeispiel bereits vereinzelt worden. Bei einem anderen Ausführungsbeispiel ist das Zwischensubstrat 54 Bestandteil einer Halbleiterscheibe, die eine Vielzahl von Zwischensubstraten 54 trägt. Das Decksubstrat 56 ist Bestandteil einer Halbleiterscheibe, die eine Vielzahl von Decksubstraten 56 trägt. Das Zwischensubstrat 54 und das Decksubstrat 56 wird in diesem Fall gemeinsam mit dem Bodensubstrat 52 vereinzelt.

Das Bodensubstrat 52, das Zwischensubstrat 54 bzw. das Decksubstrat 56 trägt Leitbahnen 62, 64 bzw. 66. Im Ausführungsbeispiel befinden sich die Leitbahnen 62, 64 bzw. 66 an der oberen Fläche des Bodensubstrats 52, des Zwischensubstrats 54 bzw. des Decksubstrats 56. Bei anderen Ausführungsbeispielen gibt es mehrere Lagen von Leitbahnen in jedem Substrat. Bei einem weiteren Ausführungsbeispiel befinden sich auch an den Rückseiten des Bodensubstrats, das Zwischensubstrats und/oder des Decksubstrats 56 Leitbahnen. Die Leitbahnen verschiedener Substrate 52 bis 56 werden durch vertikale Metallisierungen 68 untereinander verbunden, beispielsweise durch eine Metallisierung zwischen dem Bodensubstrat 52 und dem Zwischensubstrat 54 oder durch eine nicht dargestellte Metallisierung zwischen dem Decksubstrat 56 und dem Bodensubstrat 52.

Zwischen dem Bodensubstrat 52 und dem Zwischensubstrat 54 und auch zwischen dem Zwischensubstrat 54 und dem Decksubstrat 56 befindet sich ein isolierender Abstand, der beispielsweise von einem festen Dielektrikum ausgefüllt wird, beispielsweise von Siliziumdioxid. Teile einer Speicherschaltung befinden sich beispielsweise auf dem Bodensubstrat 52. Andere Teile derselben Speicherschaltung befinden sich dagegen auf dem Zwischensubstrat 54.

Figur 4 zeigt eine Draufsicht auf einen Schichtstapel 70, der ein Bodensubstrat 72 und ein darüber angeordnetes Decksubstrat 74 enthält. Weitere Substrate sind in dem Schichtstapel 70 nicht enthalten. Beispielsweise befinden sich auf dem Bodensubstrat 72 die in Figur 1 einfach umrahmten Funktionsblöcke und auf dem Decksubstrat 74 die in Figur 1 zweifach umrahmten Funktionsblöcke. Das Bodensubstrat 72 trägt entlang seines Umfangs Bondinseln 76 zum Anschluss von Bonddrähten, die zu Anschlusspins eines Gehäuses zum Einkapseln des Schichtstapels 70 führen sollen. Die Bondinseln 76 haben beispielsweise eine Länge größer als 50 µm (Mikrometer) und eine Breite größer als 50 µm, typischerweise jeweils von 100 µm.

Zwischen dem Bodensubstrat 72 und dem Decksubstrat 74 befinden sich bspw. drei Reihen von Lötverbindungen 78, im Ausführungsbeispiel insgesamt 24 Lötverbindungen 78. Die Lötverbindungen 78 enden auf Lötinseln, die beispielsweise eine Breite kleiner als 20 µm und ein Länge kleiner als 20 µm haben, typischerweise eine Größe von 10 µm x 10 µm. Die Lötverbindungen 78 werden im Rahmen einer Plättchen-Schnellmontagetechnik erzeugt, die auch als Flip-Chip-Technik oder als Face-to-Face-Technik bezeichnet wird.

Figur 5 zeigt einen Querschnitt durch den Substratstapel 70 entlang einer Reihe von Lötverbindungen 78. Leitbahnen 80, die vom Bodensubstrat 72 getragen werden, liegen Leitbahnen 82 gegenüber, die vom Decksubstrat 74 getragen werden.

Bei anderen Ausführungsbeispielen werden die Funktionsblöcke der Schaltungsanordnung 10 auf andere Art und Weise auf die beiden Substrate aufgeteilt als oben erläutert. Bei weiteren Ausführungsbeispielen enthält die Schaltungsanordnung 10 auch andere Funktionsblöcke.

Die oben erläuterten Herstellungsverfahren sind insbesondere dann mit großem Nutzen einsetzbar, wenn Technologien mit minimalen Strukturbreiten kleiner als 250 nm (Nanometer) und insbesondere kleiner oder gleich 65 nm hergestellt werden.

Bei Anwendung der Erfindung wird eine Schaltungsanordnung, die bisher auf einem Chip produziert worden ist, in zwei oder mehrere Teilchips im Hinblick auf den Herstellungsaufwand optimal aufgeteilt. Die Teilchips werden dann durch dreidimensionale Integration verbunden. Die Leistungsfähigkeit des Produkts bleibt gleich oder wird sogar erhöht. Das Auswahlkriterium wird so gewählt, dass jeder Teilchip nur eine begrenzte Anzahl voneinander verschiedene Bauelemente enthält.

Die Erfindung lässt sich sowohl bei sogenannten bulk-Substraten als auch bei SOI-Substraten (Silicon on Insulator) einsetzen.

Die folgende Tabelle zeigt einen Vergleich von Prozessschritten zwischen einem in Spalte 1 aufgelisteten sogenannten embedded-Prozess, bei dem ein nicht-flüchtiger Speicherschaltkreis mit einem Prozessor auf einem Chip angeordnet wird, und dem in den Spalten 2 und 3 aufgeführten erfindungsgemäßen Verfahren, bei dem zwei Teilchips hergestellt und später verbunden werden.

| Spalte 1 (Embedded) | Spalte 2 (Speicher) | Spalte 3 (Logik) |
|---|---|---|
| STI (shallow trench insulation) | DTI (deep trench insulation) | STI (shallow trench insulation) |
| Hochvolt (HV) n-Wanne | Hochvolt (HV) n-Wanne | |
| HV p-Wanne | HV p-Wanne | |
| Mittelvolt (MV) Vt Implantation | Mittelvolt (MV) Vt Implantation | |
| Tunnelfenster | Tunnelfenster | |
| Floatinq Gate (FG) | Floating Gate (FG) | |
| LG - bereichsweises Entfernen der FG's | LG - bereichsweises Entfernen der FG's | |
| n-Wanne | | n-Wanne |
| p-Wanne | | p-Wanne |
| Dual-Gate-Oxide | Dual-Gate-Oxide | |
| Stacked-Gate-Etch | Stacked-Gate-Etch | |
| Matrix Implantation | Matrix Implantation | |
| Gate Strukturierung | Gate Strukturierung | Gate Strukturierung |
| HV-n-LDD (low doped drain) | HV-n-LDD (low doped drain) | |
| HV-p-LDD (low doped drain) | HV-p-LDD (low doped drain) | |
| Logik NFET Kanalanschluss (extension) | | Logik NFET Kanalanschluss (extension) |
| Logik PFET Kanalanschluss | | Logik PFET Kanalanschluss |
| n+ Source/Drain | n+ Source/Drain | n+ Source/Drain |
| p+ Source/Drain | p+ Source/Drain | p+ Source/Drain |
| Silicide blockinq | Silicide blocking | Silicide blocking |
| Kontakt | Kontakt | Kontakt |
| Metall 1 | Metall 1 | Metall 1 |
| Metall 2 | Metall 2 | Metall 2 |
| Via 1 | Via 1 | Via 1 |
| Metall 3 | Metall 3 | Metall 3 |
| Via 2 | Via 2 | Via 2 |
| Metall 4 | Metall 4 | Metall 4 |
| Via 3 | Via 3 | Via 3 |
| Via letzte Kupferschicht zur Leitbahn | | Via letzte Kupferschicht zur Leitbahn |
| AlCu transfer pad | | AlCu transfer pad |
| TV (Öffnen der Passivierung zu den Anschlusspads) | | TV (Öffnen der Passivierung zu den Anschlusspads) |

Die Prozesse gemäß Spalten 2 und 3 der Tabelle sind jeweils für sich betrachtet und auch insgesamt betrachtet weniger komplex als der Prozess gemäß Spalte 1. Die Prozesse gemäß Spalte 2 bzw. 3 können an verschiedenen Produktionsstandorten durchgeführt werden.

Beispielsweise wird die auf Schnelligkeit optimierte Herstellung des nicht-flüchtigen Schaltkreises gemäß Spalte 2 mit einer Aluminiummetallisierung und einem Oxid-Intermetalldielektrikum an einem Produktionsstandort A durchgeführt. Die Herstellung der Logikschaltung gemäß spalte 3 mit Kupfermetallisierung und einem Dielektrikum mit einer kleinen Dielektrizitätskonstante kleiner 3,9 wird dagegen an einem Produktionsstandort B durchgeführt. Durch diese Vorgehensweise sinken die Kosten im Vergleich zu dem Verfahren gemäß Spalte 1 erheblich. Außerdem können beim Teilchip für den Speicherschaltkreis tiefe Grabenisolationen zur Optimierung des Flächenverbrauchs eingesetzt werden. Solche tiefen Gräben sind nicht ohne weiteres gemeinsam mit den flachen Grabenisolationen herzustellen, die für die Logikschaltung benötigt werden. Demzufolge verringern sich die Kosten pro mm' (Quadratmillimeter) Siliziumsubstrat erheblich. Die Kosten für die Verbindung der Teilschaltungen, beispielsweise durch die Face-to-Face-Technologie sind im Vergleich zu der Kostenersparnis durch die Aufteilung in zwei Prozesse klein.

Die Anzahl der Verbindungen zwischen den Teilchips hängt von der Aufteilung ab. Bei den Speicherschaltkreisen enthalten die Wortleitungs- und Bitleitungs-Dekoder Logiktransistoren. Bei dem oben erläuterten ersten Ausführungsbeispiel enthalten beide Teilchips Logiktransistoren. Die gewählte Aufteilung ermöglicht jedoch eine einfache Schnittstelle mit etwa 80 Verbindungen. Jedoch ist die Prozesskomplexität höher als beim zweiten Ausführungsbeispiel.

Beim zweiten Ausführungsbeispiel wird durch den Wortleitungs- und durch den Bitleitungs-Trakt hindurch getrennt. Die Logiktransistoren für die Wortleitungs- und Bitleitungs-Dekoder werden auf dem Logikschaltkreischip angeordnet, wohingegen die Hochvolt- und Mittelvolt-Transistoren auf dem Zellenfeld-Substrat angeordnet werden. Die Prozesskomplexität ist beim zweiten Ausführungsbeispiel im Vergleich zur Prozesskomplexität beim ersten Ausführungsbeispiel erheblich geringer. Jedoch werden mehr Verbindungen zwischen den Substraten benötigt. Das zweite Ausführungsbeispiel ist vom Kostenstandpunkt das bevorzugte. Die große Anzahl von Verbindungen lässt sich ohne bzw. mit einem hinnehmbaren Verlust in der Zugriffszeit des Speicherschaltkreises bzw. allgemein in der Performance realisieren.

In beiden Ausführungsbeispielen liegen die Gesamtkosten für die Herstellung jedoch erheblich unter den Kosten für eine entsprechende eingebettete Technologie (embedded technology). Diese Aussage gilt auch für sehr kleine Chipflächen, z.B. bei einer Summe der Chipfläche beider Substrate kleiner als 5 mm².

Die Erfindung lässt sich nicht nur auf die Trennung von Speicherschaltkreisen anwenden, sondern auch auf andere Schaltungen, die bisher nur auf einem einzigen Substrat hergestellt worden sind, beispielsweise:
- BICMOS-Schaltungen (Bipolar Complementary Metall Oxide Semiconductor) lassen sich auftrennen in CMOS-Schaltungen auf einem Substrat und Bipolar-Schaltungen auf dem andern Teilsubstrat, oder
- ein sogenannter stand-alone-Flash lässt sich aufteilen in die Zustandsmaschine auf einem Teilchip und das Zellenfeld sowie die Dekoder auf einem anderen Teilchip.

Die erläuterten Verfahren lassen sich insbesondere dann zur Herstellung von Schaltkreisen auf mehreren Substraten einsetzen, wenn innovative Verfahren zur Herstellung eines Prozessors mit minimalen Strukturabmessungen kleiner oder gleich 65 nm eingesetzt werden. Diese Technologien sind kaum noch kompatibel mit den Anforderungen an Technologien zur Herstellung von Flash-Speicherschaltkreisen.

Außerdem können Hochvolt- bzw. Mittelvolt-Transistoren auf Grund physikalischer Vorgaben nicht von einer Verringerung der minimalen Strukturbreite profitieren, d.h. die teuren Masken zur Herstellung der Logikschaltungen hätten keinen Vorteil für die Herstellung der Speicherschaltkreise. Dies trifft auch auf digitale Signalprozessoren zu, bei denen die analogen Bauelemente bzw. Schaltkreise nicht von der Verringerung der minimalen Strukturbreite für die Logikschaltung des digitalen Signalprozessors profitieren. Durch die Aufteilung auf Teilsubstrate lassen sich diese Nachteile vermeiden.

Dagegen lassen sich Logiktransistoren mit Schwellspannungen im unteren, mittleren und oberen Spannungsbereich, von z.B. 0,1 V (Volt), 0,3 V bzw. 0,5 V, auf einem Substrat fertigen, z.B. auf dem Logiksubstrat für den Prozessor 40 und den Coprozessor 44.

Insbesondere lassen sich die folgenden Probleme durch eine geschickte Aufteilung auf mehrere Chips einfacher lösen:
- Probleme betreffend ein Gate-Dielektrikum mit einer Dielektrizitätskonstante größer 3,9, insbesondere Probleme:
   - beim chemisch-mechanisches-Polieren der gestapelten Gate-Elektroden,
   - beim Realisieren eines Dielektrikums mit großer Dielektrizitätskonstante basierend auf einem ONO-Stapel (Oxid Nitrid Oxid), insbesondere hinsichtlich der Datenhaltungszeit,
   - der Verfügbarkeit eines anisotropen Ätzverfahrens für diese Dielektrika, insbesondere eines anisotrophen Ionenätzverfahrens,
   - bei der Realisierung der Seitenwandoxidation, z.B. könnte das Dielektrikum kristallisieren,
- Intermetalldielektrika mit Dielektrizitätskonstanten kleiner 3,9, beispielsweise deren Geeignetheit für höhere Spannungen oder Probleme beim Bonden auf dünne Leitbahnen, die sich in einem Dielektrikum mit geringer Dielektrizitätskonstante befinden,
- die Beanspruchung des Siliziums, beispielsweise die thermische Instabilität des auf Grund eines ONO-Verfahrens beanspruchten Siliziums,
   - insbesondere wenn das Topoxid des ONO-Stapels durch ein Hochtemperaturoxid ersetzt wird,
   - die thermische Instabilität des beanspruchten Siliziums auf Grund der Seitenwandoxidation sowie
   - Beanspruchung des Siliziums durch Versetzungen, welche die Datenhaltezeit beeinflussen,
- angehobene Source- bzw. Draingebiete und die damit zusammenhängende Erhöhung der sogenannten moving Bitrate,
- SOI-Techniken, insbesondere die Integration auf teilweise verarmten oder vollverarmten SOI-Substraten oder die Integration auf Siliziumgermanium.

## Patentansprüche

1. Speicher-Schaltungsanordnung (10),
mit einem Zellenfeldsubstrat (52), das ein in einer Speicherschaltung (12) enthaltenes integriertes Speicherzellenfeld (16) aus einer Vielzahl von Speicherzellen trägt,
mit einem Logikschaltungssubstrat (54), das mindestens eine integrierte Logikschaltung (30, 38) trägt, die den Zugriff auf die Speicherzellen im Rahmen der Grundfunktion der Speicher-Schaltungsanordnung (10) steuert,
wobei das Logikschaltungssubstrat (54) ein anderes Substrat als das Zellenfeldsubstrat (52) ist,
**dadurch gekennzeichnet, dass** die Logikschaltung (30) eine in der Speicherschaltung (12) enthaltene Dekodierschaltung (30, 34) ist, die abhängig von einem Adressdatum eine Wortleitung oder eine Bitleitung auswählt, die an mehrere Speicherzellen des Speicherzellenfeldes (16) angeschlossen ist.

2. Schaltungsanordnung (10) nach Anspruch 1, **dadurch**
**gekennzeichnet, dass** das Zellenfeldsubstrat (52) Substratoberflächen hat, die nur das Zellenfeldsubstrat (52) und nicht das Logikschaltungssubstrat (54) allseitig umgeben, und/oder dass die Speicherzellen flüchtige oder nicht-flüchtige Speicherzellen sind, insbesondere Speicherzellen eines Flash-Speichers.

3. Schaltungsanordnung (10) nach Anspruch 1 oder 2, **dadurch gekennzeichnet, dass** das die Steuerschaltung (38) Abläufe beim Lesen und/oder Abläufe beim Schreiben und/oder Abläufe beim Löschen des Inhalts einer Speicherzelle des Speicherzellenfeldes (16) steuert, und/oder dass das Logikschaltungssubstrat (54) eine Leseverstärkerschaltung (34) trägt, mit deren Hilfe sich der Speicherzustand einer Speicherzelle ermitteln lässt.

4. Schaltungsanordnung (10) nach einem der vorhergehenden Ansprüche, **dadurch gekennzeichnet, dass** die Wortleitung an Speicherzellen einer Zeile aus Speicherzellen des Speicherzellenfeldes (16) angeschlossen ist,
und/oder dass die Bitleitung an Speicherzellen einer Spalte aus Speicherzellen des Speicherzellenfeldes (16) angeschlossen ist,
und/oder durch eine elektrisch leitfähige Verbindung (68) zwischen dem Zellenfeldsubstrat (52) und dem Logikschaltungssubstrat (54) für jede Sammelleitung.

5. Schaltungsanordnung (10) nach einem der vorhergehenden Ansprüche, **dadurch gekennzeichnet, dass** das Logikschaltungssubstrat (54) eine Schaltungsanordnung mindestens eines Prozessors (40, 42) trägt, der zur Bearbeitung von Programmbefehlen geeignet ist, insbesondere zur Bearbeitung von im Speicherzellenfeld gespeicherten Programmbefehlen,
wobei insbesondere ein Prozessor (42) ein Verschlüsselungs-Prozessor ist, der im Betrieb Programmbefehle eines Verschlüsselungsprogramms ausführt, insbesondere im Speicherzellenfeld (16) gespeicherte Programmbefehle,
und/oder dass das Zellenfeldsubstrat (52) mindestens eine A-nalogschaltung trägt, insbesondere eine Spannungssensoreinheit und/oder eine Stromsensoreinheit (44) und/oder mindestens eine Analog-Digital-Wandlereinheit und/oder eine Digital-Analog-Wandlereinheit.

6. Schaltungsanordnung (10) nach einem der vorhergehenden Ansprüche, **dadurch gekennzeichnet, dass** eine Hauptfläche des Zellenfeldsubstrats (52) und eine Hauptfläche des Logikschaltungssubstrats (54) in zwei zueinander parallelen Ebenen liegen, vorzugsweise mit Überlappung in Normalenrichtung einer Hauptfläche,
oder dass eine Hauptfläche des Zellenfeldsubstrats quer zu einer Hauptfläche des Logikschaltungssubstrats liegt.

7. Verfahren zum Herstellen einer integrierten Schaltungsanordnung (10), insbesondere einer Schaltungsanordnung nach einem der vorhergehenden Ansprüche,
bei dem die folgenden Schritte ohne Beschränkung durch die angegebene Reihenfolge ausgeführt werden:
Fertigen eines integrierten Speicherzellenfeldes (16) auf einem Speicherzellenfeldsubstrat (52) mit einer ersten Folge von Verfahrensschritten,
Fertigen einer integrierten Logikschaltung zum Erbringen von Grundfunktionen des Speicherzellenfeldes (16) auf einem vom Speicherzellensubstrat (52) getrennten Logikschaltungssubstrat (54) mit einer von der ersten Folge abweichenden zweiten Folge von Verfahrensschritten,
Anordnen des integrierten Speicherzellenfeldes (52) und der integrierten Logikschaltung (54) zu einer Speicher-Schaltungsanordnung (10, 50),
**dadurch gekennzeichnet, dass** die Logikschaltung (30) eine in der Speicherschaltung (12) enthaltene Dekodierschaltung (30, 34) ist, die abhängig von einem Adressdatum eine Wortleitung oder eine Bitleitung auswählt, die an mehrere Speicherzellen des Speicherzellenfeldes (16) angeschlossen ist.

8. Verfahren nach Anspruch 7, **dadurch gekennzeichnet, dass** die erste Folge mindestens einen der folgenden Verfahrensschritte enthält, der in der zweiten Folge nicht enthalten ist:
Erzeugen von tiefen Gräben, insbesondere mit einer Tiefe größer 1 µm oder größer 2 µm,
Erzeugen mindestens einer n-Wanne oder n-Schicht und/oder mindestens einer p-Wanne oder p-Schicht für Spannungen größer 6 Volt, insbesondere mit einem für diese Spannungen geeigneten Dotiergradienten am Rand,
Erzeugen eines Tunneloxides,
Erzeugen von isolierten Elektroden zwischen zwei Oxidschichten,
Entfernen ausgewählter Elektroden über isolierten Elektroden, Erzeugen von Oxidbereichen mit einer Dicke größer 50 nm, Erzeugen von Kanalanschlussgebieten für Spannungen größer 6 Volt,
und/oder dass die zweite Folge mindestens einen der folgenden Verfahrensschritte enthält, der in der ersten Folge nicht enthalten ist:
Erzeugen von flachen Gräben, insbesondere mit einer Tiefe kleiner als 1 µm oder kleiner als 0,5 µm,
Erzeugen mindestens einer n-Wanne oder n-Schicht und/oder mindestens einer p-Wanne oder p-Schicht für Spannungen kleiner als 5 Volt oder kleiner als 2,5 Volt,
Erzeugen von Kanalanschlussgebieten für Spannungen kleiner als 5 Volt oder kleiner als 2,5 Volt,
Erzeugen mindestens einer Metallisierungslage mehr als in der ersten Folge.

9. Verfahren nach Anspruch 7 oder 8, **gekennzeichnet durch** den Schritt:
Anordnen des Speicherzellensubstrats (52) und des Logikschaltungssubstrats (54) mit Hilfe der Plättchen-SchnellmontageTechnik oder mit Hilfe eines 3D-Integrationsverfahrens.

## Claims

1. Memory circuit arrangement (10),
having a cell array substrate (52), which carries an integrated memory cell array (16) contained in a memory circuit (12) and comprising a multiplicity of memory cells,
having a logic circuit substrate (54), which carries at least one integrated logic circuit (30, 38) that controls the access to the memory cells in the context of the basic function of the memory circuit arrangement (10),
the logic circuit substrate (54) being a different substrate than the cell array substrate (52),
**characterized in that** the logic circuit (30) is a decoding circuit (30, 34) which is contained in the memory circuit (12) and which, in a manner dependent on an address datum, selects a word line or a bit line connected to a plurality of memory cells of the memory cell array (16).

2. Circuit arrangement (10) according to Claim 1, **characterized in that** the cell array substrate (52) has substrate surfaces which surround only the cell array substrate (52) and not the logic circuit substrate (54) on all sides, and/or **in that** the memory cells are volatile or nonvolatile memory cells, in particular memory cells of a flash memory.

3. Circuit arrangement (10) according to Claim 1 or 2, **characterized in that** the control circuit (38) controls sequences when reading and/or sequences when writing and/or sequences when erasing the content of a memory cell of the memory cell array (16), and/or **in that** the logic circuit substrate (54) carries a sense amplifier circuit (34), with the aid of which the memory state of a memory cell can be determined.

4. Circuit arrangement (10) according to one of the preceding claims, **characterized in that** the word line is connected to memory cells of a row of memory cells of the memory cell array (16), and/or **in that** the bit line is connected to memory cells of a column of memory cells of the memory cell array (16), and/or by an electrically conductive connection (68) between the cell array substrate (52) and the logic circuit substrate (54) for each collective line.

5. Circuit arrangement (10) according to one of the preceding claims, **characterized in that** the logic circuit substrate (54) carries a circuit arrangement of at least one processor (40, 42) which is suitable for processing program instructions, in particular for processing program instructions stored in the memory cell array, in particular a processor (42) being an encryption processor which, during operation, executes program instructions of an encryption program, in particular program instructions stored in the memory cell array (16), and/or **in that** the cell array substrate (52) carries at least one analogue circuit, in particular a voltage sensor unit, and/or a current sensor unit (44), and/or at least one analogue-to-digital converter unit, and/or a digital-to-analogue converter unit.

6. Circuit arrangement (10) according to one of the preceding claims, **characterized in that** a main area of the cell array substrate (52) and a main area of the logic circuit substrate (54) lie in two planes parallel to one another, preferably with overlapping in the direction of the normal to a main area, or **in that** a main area of the cell array substrate is situated transversely with respect to a main area of the logic circuit substrate.

7. Method for producing an integrated circuit arrangement (10), in particular a circuit arrangement according to one of the preceding claims, in which the following steps are performed without any restriction by the order specified:
fabrication of an integrated memory cell array (16) on a memory cell array substrate (52) by means of a first sequence of method steps,
fabrication of an integrated logic circuit for providing basic functions of the memory cell array (16) on a logic circuit substrate (54) separate from the memory cell substrate (52), by means of a second sequence of method steps, which differs from the first sequence,
arrangement of the integrated memory cell array (52) and the integrated logic circuit (54) to form a memory circuit arrangement (10, 50), **characterized in that** the logic circuit (30) is a decoding circuit (30, 34) which is contained in the memory circuit (12) and which, in a manner dependent on an address datum, selects a word line or a bit line connected to a plurality of memory cells of the memory cell array (16).

8. Method according to Claim 7, **characterized in that** the first sequence contains at least one of the following method steps which is not contained in the second sequence:
production of deep trenches, in particular having a depth of greater than 1 µm or greater than 2 µm,
production of at least one n-type well or n-type layer and/or at least one p-type well or p-type layer for voltages of greater than 6 volts, in particular with a doping gradient suitable for said voltages at the edge,
production of a tunnel oxide,
production of insulated electrodes between two oxide layers,
removal of selected electrodes above insulated electrodes,
production of oxide regions having a thickness of greater than 50 nm,
production of channel connection zones for voltages of greater than 6 volts,
and/or **in that** the second sequence contains at least one of the following method steps which is not contained in the first sequence:
production of shallow trenches, in particular having a depth of less than 1 µm or less than 0.5 µm,
production of at least one n-type well or n-type layer and/or at least one p-type well or p-type layer for voltages of less than 5 volts or less than 2.5 volts,
production of channel connection zones for voltages of less than 5 volts or less than 2.5 volts,
production of at least one metallization layer more than in the first sequence.

9. Method according to Claim 7 or 8 **characterized by** the following step:
arrangement of the memory cell substrate (52) and the logic circuit substrate (54) with the aid of the rapid chip mounting technique or with the aid of a 3D integration method.

## Revendications

1. Système ( 10 ) de mémoire,
comprenant un substrat ( 52 ) de champ de cellules, qui porte un champ ( 16 ) de cellules de mémoire intégrées contenu dans un circuit ( 12 ) de mémoire et constitué d'une pluralité de cellules de mémoire,
comprenant un substrat ( 54 ) de circuit logique, qui porte au moins un circuit ( 30, 38 ) logique intégré commandant l'accès aux cellules de mémoire dans le cadre de la fonction de base du système ( 10 ) de mémoire,
dans lequel le substrat ( 54 ) du circuit logique est un autre substrat que le substrat ( 52 ) du champ de cellules,
**caractérisé en ce que** le circuit ( 30 ) logique est un circuit ( 30, 34 ) de décodage, qui est contenu dans le circuit ( 12 ) de mémoire et qui choisit, en fonction d'une donnée d'adresse, une ligne de mots ou une ligne de bits raccordée à plusieurs cellules de mémoire du champ ( 16 ) de cellules de mémoire.

2. Système ( 10 ) suivant la revendication 1,
**caractérisé en ce que** le substrat ( 52 ) du champ de cellules a des surfaces de substrat qui entourent de tous côtés seulement le substrat ( 52 ) de champ de cellules et non le substrat ( 54 ) de circuit logique et/ou **en ce que** les cellules de mémoire sont des cellules de mémoire volatiles ou non volatiles, notamment des cellules de mémoire d'une mémoire flash.

3. Système ( 10 ) suivant la revendication 1 ou 2, **caractérisé en ce que** le circuit ( 38 ) de commande commande des déroulements à la lecture et/ou des déroulements à l'écriture et/ou des déroulements à l'effacement du contenu d'une cellule de mémoire du champ ( 16 ) de cellules de mémoire,
et/ou **en ce que** le substrat ( 54 ) du circuit logique porte un circuit ( 34 ) d'amplificateur de lecture, à l'aide duquel l'état de mémoire d'une cellule de mémoire peut être déterminé.

4. Système ( 10 ) suivant l'une des revendications précédentes, **caractérisé en ce que** la ligne de mots est raccordée à des cellules de mémoire d'une ligne de cellules de mémoire du champ ( 16 ) de cellules de mémoire,
et/ou **en ce que** la ligne de bits d'une cellule de mémoire est raccordée à une colonne de cellules de mémoire du champ ( 16 ) de cellules de mémoire,
et/ou par une liaison ( 68 ) conductrice de l'électricité entre le substrat ( 52 ) de champ de cellules et le substrat ( 54 ) de circuit logique pour chaque conducteur collecteur.

5. Système ( 10 ) suivant l'une des revendications précédentes, **caractérisé en ce que** le substrat ( 54 ) ce circuit logique porte un système d'au moins un processeur ( 40, 42 ) qui est approprié au traitement d'instructions de programme, notamment au traitement d'instructions de programme mémorisées dans le champ de cellules de mémoire, un processeur ( 42 ) étant notamment un processeur de chiffrement qui exécute en fonctionnement des instructions d'un programme de chiffrement, notamment des instructions de programme mémorisées dans le champ ( 16 ) de cellules de mémoire,
et/ou **en ce que** le substrat ( 52 ) de champ de cellules porte au moins un circuit analogique, notamment une unité de capteur de tension et/ou une unité ( 44 ) de capteur de courant et/ou au moins une unité de convertisseur analogique-numérique et/ou une unité de convertisseur numérique-analogique.

6. Système ( 10 ) suivant l'une des revendications précédentes, **caractérisé en ce qu'**une surface principale du substrat ( 52 ) de champ de cellules et une surface principale du substrat ( 54 ) de circuit logique se trouvent dans deux plans parallèles entre eux avec, de préférence, chevauchement dans la direction normale d'une surface principale,
ou **en ce qu'**une surface principale du substrat de champ de cellules est transversale à une surface principale du substrat de circuit logique.

7. Procédé de production d'un système ( 10 ) intégré, notamment d'un système suivant l'une des revendications précédentes,
dans lequel on exécute les stades suivants sans limitation par l'ordre de succession indiqué :
on prépare un champ ( 16 ) de cellules intégrées sur un substrat ( 52 ) de cellules de mémoire par une première succession de stades de procédé,
on prépare un circuit logique intégré pour apporter des fonctions de base du champ ( 16 ) de cellules de mémoire sur un substrat ( 54 ) de circuit logique séparé du substrat ( 52 ) de cellules de mémoire par une deuxième succession de stades de procédé s'écartant de la première succession,
on dispose le champ ( 52 ) de cellules de mémoire intégrées et le circuit ( 54 ) logique intégré en un système ( 10, 50 ) de mémoire,
**caractérisé en ce que** le circuit ( 30 ) logique est un circuit ( 30, 34 ) de décodage, qui est contenu dans le circuit ( 12 ) de mémoire et qui choisit en fonction d'une donnée d'adresse une ligne de mots ou une ligne de bits, raccordée à plusieurs cellules de mémoire du champ ( 16 ) de cellules de mémoire.

8. Procédé suivant la revendication 7, **caractérisé en ce que** la première succession comprend au moins l'un des stades de procédé suivant, qui n'est pas compris dans la deuxième succession :
production de sillons profonds, notamment d'une profondeur supérieure à 1 µm ou supérieure à 2 µm,
production d'au moins un caisson n ou d'une couche n et/ou d'au moins un caisson p ou d'une couche p pour des tensions plus hautes que 6 volts, en ayant notamment au bord un gradient de dopage approprié à ces tensions,
production d'un oxyde de tunnel,
production d'électrodes isolées entre deux couches d'oxyde,
élimination d'électrodes sélectionnées au-dessus d'électrodes isolées,
production de zones d'oxyde d'une épaisseur supérieure à 50 nm,
production de domaines de bornes de canal pour des tensions plus hautes que 6 volts,
et/ou **en ce que** la deuxième succession comprend au moins l'un des stades de procédé suivants, qui n'est pas compris dans la première succession :
production de sillons plats, notamment d'une épaisseur plus petite que 1 µm ou plus petite que 0,5 µm,
production d'au moins un caisson n ou d'une couche n et/ou d'au moins un caisson p ou d'une couche p pour des tensions plus basses que 5 volts ou plus basses de 2,5 volts,
production de régions de bornes de canal pour des tensions plus basses que 5 volts ou plus basses que 2,5 volts,
production d'au moins une couche de métallisation de plus que dans la première succession.

9. Procédé suivant la revendication 7 ou 8,
**caractérisé par** le stade :
on dispose le substrat ( 52 ) de cellules de mémoire et le substrat ( 54 ) logique à l'aide d'une technique de montage rapide de plaquettes ou à l'aide d'un procédé d'intégration en 3D.
